# EUROPÄISCHE PATENTSCHRIFT

(11) **EP 1 004 228 B1**
(45) Veröffentlichungstag und Bekanntmachung des Hinweises auf die Patenterteilung: **27.03.2002**
(21) Anmeldenummer: 98948777.2
(22) Anmeldetag: 12.08.1998
(51) Int. Cl.: H05K 7/10

(54) **VORRICHTUNG ZUR KONTAKTSICHERUNG BEIM LÖTEN VON HOCHPOLIGEN IC-STECKVERBINDERN**
DEVICE FOR CONTACT STABILITY DURING SOLDERING OF HIGH POLE IC CONNECTORS
DISPOSITIF DE MISE EN CONTACT FIABLE LORS DU BRASAGE DE CONNECTEURS A FICHES POUR CIRCUITS INTEGRES A POLE ELEVE

(30) Priorität: 13.08.1997 DE 19735134
(43) Veröffentlichungstag der Anmeldung: 31.05.2000
(73) Patentinhaber: Fujitsu Siemens Computers GmbH, 81739 München (DE)
(72) Erfinder: STREBLE, Bernd, D-86316 Friedberg (DE); PETRY, Florian, D-86179 Augsburg (DE)
(74) Vertreter: Hermann, Uwe, Dipl.-Ing.
(86) Internationale Anmeldenummer: DE9802322
(87) Internationale Veröffentlichungsnummer: WO9909797

(56) Entgegenhaltungen:
- EP-A- 0 651 471
- WO-A-91/16740
- DE-A- 3 418 694

## Beschreibung

Die Erfindung betrifft eine Vorrichtung zur Kontaktsicherung beim Löten von hochpoligen IC-Steckverbindern gemäß dem Oberbegriff des Anspruchs 1. EP-A-0 651 471 zeigt eine solche Vorrichtung zur Kontaktsicherung.

Hochpolige IC-Steckverbinder, beispielsweise solche für PC-Prozessoren, die unter anderem auch in Form von sogenannten Zero-Insertion-Force-Steckverbindern (ZIF-Steckverbindern) bekannt sind, werden mit ihren vielen, über eine Fläche verteilten Anschlussstellen (Pole; Pins) auf Leiterplatten aufgelötet, um dann für einen zugehörigen IC-Baustein, beispielsweise einem Prozessorbaustein, ein lösbares Kontaktmittel zu sein, in das der IC-Baustein in einfacher Weise eingesteckt und gegebenenfalls zerstörungsfrei wieder herausgenommen werden kann. Diese IC-Steckverbinder können in der Weise ausgebildet sein, dass sie nach einer entsprechenden mechanischen Montage entweder in Durchstecktechnik (THT-Technik) oder in Oberflächenmontagetechnik (SMT-Technik) auf die Leiterplatten gelötet werden. Das Löten wird dabei maschinell durchgeführt.

Mit der ständig steigenden Pol- bzw. Pinzahl der IC-Steckverbinder und der damit ständig größer werdenden Fläche, über die die Pole- bzw. Pins verteilt angeordnet sind, wird auch immer mehr Wärmezufuhr benötigt, um die IC-Steckverbinder auf die Leiterplatten löten zu können. Mit der benötigten immer größeren Wärmezufuhr steigt aber auch immer mehr die Tendenz der Leiterplatte zu verwölben. Die Folge davon ist, dass bei der SMT-Technik die Anschlussstellen des IC-Steckverbinders von der Leiterplatte abheben. Bei der Durchstecktechnik bedeutet das, dass die Anschlussstifte der bei dieser Technik mit Anschlussstiften versehenen Anschlussstellen nicht mehr ausreichend durch die für diese Anschlussstifte in den Leiterplatten vorgesehenen Bohrungen hindurchgreifen. Eine Qualitätsbeurteilung über die elektrischen Kontaktzustände zwischen den Anschlussstellen der IC-Steckverbinder und den Leiterplatten ist daher zumindest ohne weiteres nicht mehr möglich.

Um bei der Durchstecktechnik eine Qualitätsbeurteilung über die Kontaktzustände zwischen den Anschlussstellen der IC-Steckverbinder und den Leiterplatten vornehmen zu können, ist bekannt, vor dem eigentlichen Löten der IC-Steckverbinder auf die Leiterplatten in einem aufwendigen zusätzlichen Arbeitsgang mit hochschmelzendem Lot einzelne strategisch günstig plazierte Anschlussstellen der IC-Steckverbinder vorzulöten, so dass beim anschließenden maschinellen Löten der jeweils restlichen Anschlussstellen der IC-Steckverbinder ein Verwölben der Leiterplatten und damit ein Herausgleiten der Anschlussstifte der Steckverbinder aus den entsprechenden Bohrungen der Leiterplatten verhindert wird. Bei der SMT-Technik ist eine Lösung dieses Problems nicht bekannt.

Aufgabe der Erfindung ist daher, unabhängig von der Technik des Aufbringens der IC-Steckverbinder auf die Leiterplatten technische Maßnahmen anzugeben, durch die auch bei steigender Anzahl von Anschlussstellen bei den IC-Steckverbindern ohne weiteres eine Qualitätsbeurteilung bezüglich der elektrischen Kontaktzustände zwischen den Anschlussstellen der IC-Steckverbinder und der Leiterplatten nach dem maschinellen Auflöten der IC-Steckverbinder auf die Leiterplatten möglich ist.

Gelöst wird diese Aufgabe ausgehend von Steckverbindern der eingangs genannten Art durch eine zur Kontaktsicherung beim Löten dienende Vorrichtung, die die im kennzeichnenden Teil des Anspruchs 1 angegebenen Merkmale aufweist.

Die Vorrichtung umfasst Niederhalter, die den Körpern der IC-Steckverbinder an bezüglich eines planen Niederhaltens strategisch wichtigen Punkten hinzugefügt sind. Die Niederhalter weisen rastnasenartige Ausformungen auf, die nach einer mechanischen Montage der IC-Steckverbinder Gegenschulter an der Leiterplatte hintergreifen. Das Hintergreifen erfolgt dabei in der Weise, dass selbst bei der Tendenz der Leiterplatte sich zu wölben auf Grund der Wärmezufuhr beim Löten der IC-Steckverbinder die Pins bzw. Pole der hochpoligen Steckverbinder elektrisch mit der Leiterplatte kontaktiert sind, weil die Leiterplatte durch den mechanisch fixierten IC-Steckverbinder am Verwölben zumindest in dem Bereich, der für den IC-Steckverbinder wichtig ist, gehindert wird. Die Niederhalter verhindern also, dass die Anschlussstellen der IC-Steckverbinder beim Löten von der Leiterplatte abheben bzw. mit ihren Anschlussstiften aus den Bohrungen herausgleiten. Die Qualität bezüglich der Kontaktzustände zwischen den Anschlussstellen des IC-Steckverbinders und der Leiterplatte kann somit wieder garantiert werden, und zwar unabhängig davon, in welcher Technik die IC-Steckverbinder auf die Leiterplatte montiert sind.

Vorteilhafte Ausgestaltungen der Erfindung sind Gegenstand von Unteransprüchen. Danach sind die Niederhalter stiftartig mit einem halbierenden Schlitz und konisch zulaufenden Spitzenbereich ausgebildet mit dem Vorteil, dass die Niederhalter bei der mechanischen Montage in Bohrungen der Leiterplatte leicht einfasen und nach einem erfolgten Durchgriff durch die Leiterplatte hinter der Leiterplatte durch schnappartiges Auseinandergehen der Einzelstifthälften einfach einrasten können. Die IC-Steckverbinder sind auf diese einfache Weise sofort zentriert und befestigt. Sind die Niederhalter bereits an den Körper der IC-Steckverbinder angeformt, sind die IC-Steckverbinder mit einem Handgriff montiert. Da die IC-Steckverbinder in der Regel aus einem spritzbaren Material bestehen, können sie mit der Herstellung der IC-Steckverbinder angespritzt werden. Werden die Niederhalter metallisch ausgeführt, halten sie größeren Kräften stand und können gleichzeitig für eine zusätzliche Kontaktierung wie beispielsweise einer zusätzlichen bzw. verbesserten Masseverbindung verwendet werden.

Nachfolgend wird ein Ausführungsbeispiel der Erfindung anhand einer Zeichnung näher erläutert. Darin zeigen
- Figur 1: eine Draufsicht auf die Unterseite eines IC-Steckverbinders gemäß der Erfindung,
- Figur 2: eine Vorderansicht des IC-Steckverbinders gemäß der Figur 1 und
- Figur 3: eine Seitenansicht des IC-Steckverbinders gemäß der Figur 1.

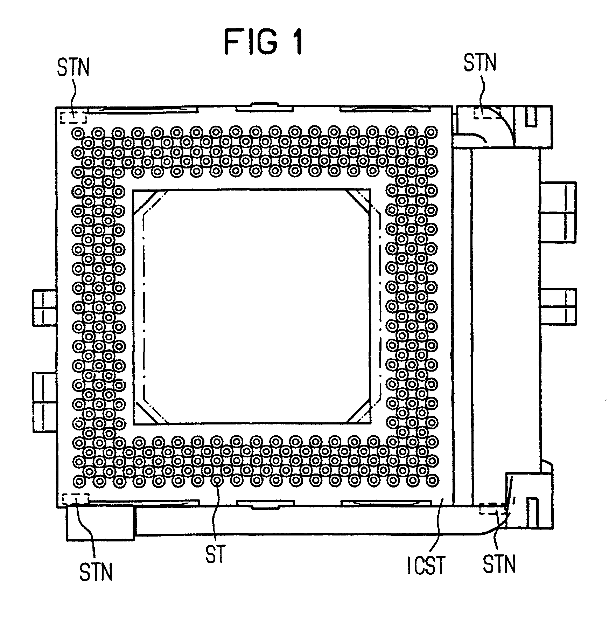

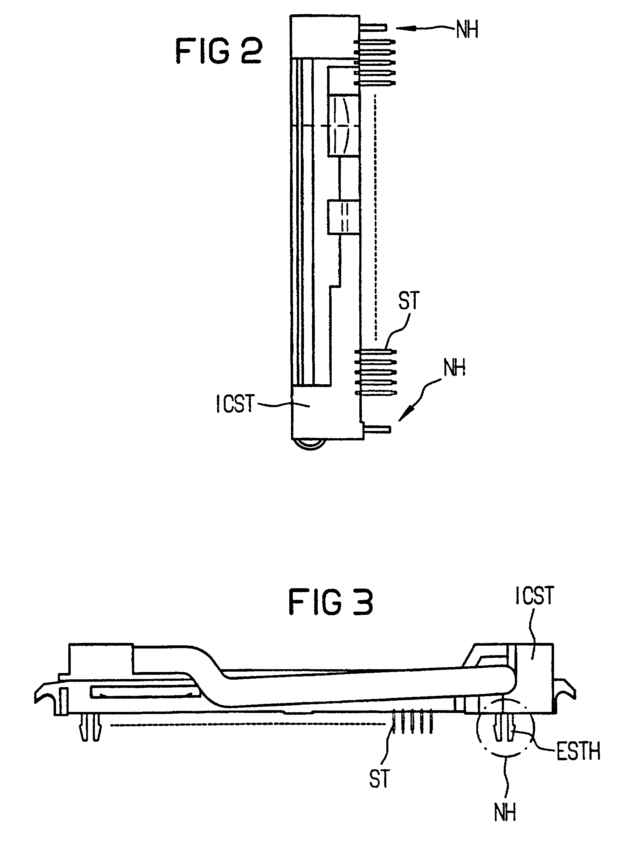

In den Figuren 1 bis 3 ist ein hochpoliger IC-Steckverbinder ICST zu sehen, der Anschlussstellen über einen Flächenbereich aufweist. Die Anschlussstellen sind als Stifte ST ausgeführt, weshalb der gezeigte IC-Steckverbinder ICST für die Durchstecktechnik geeignet ist. An bezüglich eines planen Niederhaltens des Steckverbinders ICST strategisch wichtigen Stellen STN (Figur 1) weist der IC-Steckverbinder ICST Niederhalter NH (Figuren 2 und 3) auf, die den IC-Steckverbinder ICST beim maschinellen Löten auf eine in der Zeichnung nicht näher dargestellte Leiterplatte vor einem Abheben hindern, wenn die Leiterplatte in Folge der zugeführten Wärme zum Verwölben tendiert. Die strategischen Stellen STN sind im vorliegenden Ausführungsbeispiel in den Eckbereichen des Körpers des IC-Steckverbinders und dort wiederum an den angeordnet. Es ist aber klar, dass möglicherweise andere Stellen günstiger sind, wenn beispielsweise die über die Fläche vorgenommene Verteilung der Anschlussstellen des IC-Steckverbinders ICST anders ist.

Die Niederhalter NH bestehen im gezeigten Ausführungsbeispiel jeweils aus zwei in schlitzbreitem Abstand gegenüberliegend angeordneten Einzelstifthälften ESTH, von denen jede zum freien Endbereich hin zunächst eine gegenüber der jeweils anderen Einzelstifthälfte ESTH voneinander wegweisende rastnasenartige Ausformung und dann weiter zum Spitzenbereich hin einen konisch zulaufenden Kantenverlauf hat. Auf diese Weise ermöglichen die Niederhalter, in einfacher Weise in zugeordnete Bohrungen in der Leiterplatte eingeführt zu werden, um dann nach leichtem Druck auf den Körper des IC-Steckverbinders ICST auf der Leiterplatte hinter zugehörigen Gegenschultern einzurasten. Das Einrasten wird dadurch ermöglicht, dass durch den schlitzbreiten Abstand der Einzelstifthälften ESTH und die rastnasenartige Ausformungen die Einzelstifthälften ESTH beim Durchtritt durch die zugeordneten Bohrungen in der Leiterplatte zuerst federnd zusammengedrückt und nach den Bohrungen wieder freigelassen werden, wodurch sich die rastnasenartigen Ausformungen der Einzelstifthälften ESTH an der hinteren Oberfläche der Leiterplatte verhaken. Ein Enthaken ist beispielsweise durch bewusstes zusammendrücken der Einzelstifthälften ESTH möglich. Durch das Verhaken an der Leiterplatte bleibt der IC-Steckverbinder ICST beim maschinellen Löten auf der Oberfläche der Leiterplatte plan liegen, selbst wenn diese beim Löten aufgrund der Wärmezufuhr zum Verwölben tendiert.

Ist der der Gegenschulter der Leiterplatte zugeordnete Kantenverlauf der rastnasenförmigen Ausformung einer Einzelstifthälfte ESTH derart gewählt, dass er in Bezug auf ein Abziehen des IC-Steckverbinders ICST von der Leiterplatte eine Art Anlauf schräge bildet, kann der IC-Steckverbinder ohne extriges Zusammendrücken der jeweiligen zusammengehörigen Einzelstifthälften ESTH einfach durch eine entsprechend erhöhte Zugkraft abgezogen werden. Durch den anlaufschrägenartigen Kantenverlauf werden die jeweils zusammengehörenden Einzelstifthälften ESTH automatisch zusammengedrückt.

## Patentansprüche

1. Vorrichtung zur Kontaktsicherung beim Löten von über eine Fläche verteilt hochpoligen IC-Steckverbindern auf Leiterplatten, **dadurch gekennzeichnet, dass** an den Körpern der IC-Steckverbinder (ICST) an bezüglich eines planen Niederhaltens auf die Leiterplatte strategisch wichtigen Punkten Niederhalter (NH) vorgesehen sind, die rastnasenartige Ausformungen aufweisen, die nach einer erfolgten mechanischen Montage der IC-Steckverbinder (ICST) auf die Leiterplatte Gegenschulter der Leiterplatte derart hintergreifen, dass die Pole der IC-Steckverbinder (ICST) selbst bei Tendenzen der Leiterplatte zu Verwölbungen auf Grund von Wärmezufuhr beim Löten der IC-Steckverbinder (ICST) auf die Leiterplatte mit der Leiterplatte elektrisch kontaktiert sind.

2. Vorrichtung nach Anspruch 1, **dadurch gekennzeichnet, dass** die Niederhalter (NH) stiftartig mit einem halbierenden Schlitz und konisch zulaufendem Spitzenbereich ausgebildet sind.

3. Vorrichtung nach Anspruch 1 oder 2, **dadurch gekennzeichnet, dass** die Niederhalter (NH) an den Körpern der IC-Steckverbindern (ICST) unmittelbar angeformt sind.

4. Vorrichtung nach Anspruch 1 oder 2, **dadurch gekennzeichnet, dass** die Niederhalter (NH) metallisch ausgeführt sind.

## Claims

1. Apparatus for securing contacts during soldering of IC plug connectors with a large number of pins distributed over an area, on printed circuit boards, **characterized in that** hold-down devices (NH) are provided on the bodies of the IC plug connectors (ICST) at points which are strategically important for holding them down flat on the printed circuit board, and have formed-out regions like latching tabs which, once the IC plug connector (ICST) has been mechanically mounted on the printed circuit board, engage behind mating shoulders on the printed circuit board such that the poles of the IC plug connectors (ICST) make electrical contact with the printed circuit board even if said printed circuit board has a tendency to bulge as a result of the heat supplied whilst soldering the IC plug connectors (ICST) to the printed circuit board.

2. Apparatus according to Claim 1, **characterized in that** the hold-down devices (NH) are designed like pins with a bisecting slot and a conically pointed tip region.

3. Apparatus according to Claim 1 or 2, **characterized in that** the hold-down devices (NH) are integrally formed directly on the bodies of the IC plug connectors (ICST).

4. Apparatus according to Claim 1 or 2, **characterized in that** the hold-down devices (NH) are metallic.

## Revendications

1. Dispositif de mise en contact fiable lors du brasage de connecteurs à fiches pour circuits intégrés à pôle élevé sur des plaquettes à circuits imprimés, **caractérisé en ce qu'**il est prévu sur les corps des connecteurs à fiches pour circuits imprimés (ICST), en des points stratégiquement importants en ce qui concerne un maintien à plat sur la plaquette à circuits imprimés, des serre-flans (NH) qui comportent des conformations du type à bec d'encliquetage qui, après que le montage mécanique du connecteur à enfichage pour circuits imprimés (ICST) a été effectué sur la plaquette à circuits imprimés, s'accrochent à des contre-épaulements de la plaquette à circuits imprimés, de façon que les pôles du connecteur à enfichage pour circuits imprimés (ICST), même lorsque la plaquette à circuits imprimés a tendance à se bomber en raison de l'apport de chaleur lors du brasage des connecteurs à enfichage pour circuits imprimés (ICST) pour la plaquette à circuits imprimés, sont en contact électrique avec la plaquette à circuits imprimés.

2. Dispositif suivant la revendication 1, **caractérisé en ce que** les serre-flans (NH) sont constitués en forme de tige, ayant une fente qui les séparent en deux et une partie de pointe conique.

3. Dispositif suivant la revendication 1 ou 2, **caractérisé en ce que** les serre-flans (NH) sont issus directement des corps des connecteurs à enfichage pour circuits imprimés (ICST).

4. Dispositif suivant la revendication 1 ou 2, **caractérisé en ce que** les serre-flans (NH) sont métalliques.
